(19) **Europäisches Patentamt**

**European Patent Office**

**Office européen des brevets**

(11) **EP 0 924 860 B1**

(12) **EUROPÄISCHE PATENTSCHRIFT**

(45) Veröffentlichungstag und Bekanntmachung des Hinweises auf die Patenterteilung:
**03.07.2002 Patentblatt 2002/27**

(51) Int Cl.$^7$: **H03K 17/10**, H03K 17/73

(21) Anmeldenummer: **98123820.7**

(22) Anmeldetag: **15.12.1998**

(54) **Verfahren und Schaltungsanordnung zur Sperrspannungsausgleichsregelung in einer Reihenschaltung gate-gesteuerter Halbleiter**

Method and circuitry for controlling and equalising the blocking voltages of series-connected, gate-controlled semiconductors

Procédé et dispositif de régulation et d'équilibrage des tensions de blocage de semi-conducteurs commandés par la grille et montés en série

(84) Benannte Vertragsstaaten:
**CH DE FR GB LI**

(30) Priorität: **17.12.1997 DE 19755984**

(43) Veröffentlichungstag der Anmeldung:
**23.06.1999 Patentblatt 1999/25**

(73) Patentinhaber: **Alcatel Alsthom Compagnie Générale d'Electricité 75008 Paris (FR)**

(72) Erfinder:
- **Hohmuth, Günther 12055 Berlin (DE)**
- **Boni, Marco 10627 Berlin (DE)**
- **Schütt, Hartmut 10711 Berlin (DE)**
- **Wagnitz, Reinhard 13509 Berlin (DE)**

(74) Vertreter: **Dreiss, Fuhlendorf, Steimle & Becker Patentanwälte, Postfach 10 37 62 70032 Stuttgart (DE)**

(56) Entgegenhaltungen:
EP-A- 0 288 422  WO-A-95/25383
WO-A-97/38491  DE-A- 4 241 174
US-A- 4 692 643

- **PATENT ABSTRACTS OF JAPAN vol. 011, no. 390 (E-567), 19. Dezember 1987 & JP 62 154815 A (TOSHIBA CORP), 9. Juli 1987**

**Beschreibung**

Die Erfindung betrifft ein Verfahren und eine Schaltungsanordnung zur Sperrspannungsausgleichsregelung von reihengeschalteten gategesteuerten Halbleitern nach den Oberbegriffen der Ansprüche 1 bis 3.

Eine solche Reihenschaltung von gategesteuerten Halbleitern ist immer dann erforderlich, wenn beispielsweise die Spannung in einem Stromrichterzweig die Sperrspannung eines einzelnen gategesteuerten Halbleiters überschreitet. Es ist allgemein bekannt, dass die Abschaltverzugszeit gategesteuerter Halbleiter exemplarabhängig ist, so dass beim Schalten der gategesteuertern Halbleiter vom leitenden in den gesperrten Zustand der durch die Reihenschaltung fließenden Laststrom zu verschiedenen Zeitpunkten in die parallel zu den gategesteuerten Halbleitern liegenden Beschaltungskondensatoren kommutiert. Als Folge davon werden die Beschaltungskondensatoren auf unterschiedliche Spannungen aufgeladen, so dass eine ungleichmäßige Spannungsaufteilung auf die in Reihe geschalteten gategesteuerten Halbleiter auftritt. In ungünstigen Fällen kann das zu einer Zerstörung eines gategesteuerten Halbleiters führen.

Zur Vergleichmäßigung der Spannungsaufteilung an einer Reihenschaltung unterschiedlich lange Abschaltzeiten aufweisender, gategesteuerter Halbleiter ist bereits ein Verfahren angegeben worden, mit dem die tatsächliche Spannung an jedem Halbleiter mit dem auf ihn entfallenden Teil der Gesamtspannung an der Reihenschaltung verglichen wird, vgl. EP-B1-0 288 422. Das Verfahren ist für einen Umrichter mit Spannungszwischenkreis vorgesehen. Bei diesem Verfahren werden die Sperrspannungen der Halbleiter zu unterschiedlichen Zeitpunkten abgetastet. Das würde bei Stromzwischenumkreisrichtern, bei denen sich die Sperrspannung während der Sperrphase ändert, zu falschen Ergebnissen führen.

Weiterhin ist eine Schaltungsanordnung zur Symmetrierung der Spannungsaufteilung beim Abschalten einer Reihenschaltung gategesteuerter Leistungshalbleiterschalter im Spannungszwischenkreis-Stromrichter bekannt, bei der in Abhängigkeit von der mit einer Messeinrichtung gemessenen Sperrspannung einer Freilaufdiode, die jedem gategesteuerten Leistungshalbleiterschalter zugeordnet ist, das Schaltsignal für den gategesteuerten Leistungshalbleiterschalter im Sinne einer Symmetrierung der Spannung an den Leistungshalbleiterschaltern verschoben wird, vgl. DE-C1-195 39 554.

Diese Schaltungsanordnung ist speziell für einen Spannungszwischenkreis-Stromrichter konzipiert. Bei einem Stromrichter mit Stromzwischenkreis sind die genannten Freilaufdioden nicht vorhanden, so dass die Anwendung der beschriebenen Schaltungsanordnung auf ein bestimmtes Einsatzgebiet beschränkt ist.

Weiterer Stand der Technik ist aus der US-A-4 692 643 und der WO-A-95 25 383 bekannt.

Mit der Erfindung soll nun die Aufgabe gelöst werden, ein Verfahren und eine Schaltungsanordnung zur Sperrspannungsausgleichsregelung anzugeben, die universell bei Reihenschaltungen von gategesteuerten Halbleitern in Zweigen von beliebigen Stromrichterschaltungen einsetzbar sind.

Diese Aufgabe wird mit dem im Anspruch 1 beschriebenen Verfahren und der im Anspruch 3 beschriebenen Schaltungsanordnung gelöst.

Das Wesen der Erfindung besteht darin, daß die Löschung der in Reihe geschalteten gategesteuerten Halbleiter zu unterschiedlichen Zeitpunkten eingeleitet wird, so daß sie gleichzeitig abschalten. Der Löschbeginn wird vom Vergleich der Sperrspannung zweier gategesteuerter Halbleiter abhängig gemacht, indem aus dem Vergleichsergebnis die zeitliche Lage des Löschbeginns ermittelt wird.

Die Erfindung wird nunmehr an einem Ausführungsbeispiel erläutert. Da das Problem der unterschiedlichen Abschaltverzugszeit bei gleichzeitigem Löschbeginn in praktischen Fällen insbesondere bei der Reihenschaltung von GTO-Thyristoren von Bedeutung ist, wird das Ausführungsbeispiel bei Verwendung von GTO-Thyristoren beschrieben. In der dazugehörigen Zeichnung zeigen

Fig.1  ein Schaltbild für eine Reihenschaltung von GTO-Thyristoren mit der zugehörigen Ansteuerschaltung,

Fig. 2  ein Schaltbild für eine Ansteuerschaltung und

Fig. 3a, 3b, 3c, 3d  eine Darstellung von Zeitfunktionen charakteristischer Strom-und Spannungsverläufe

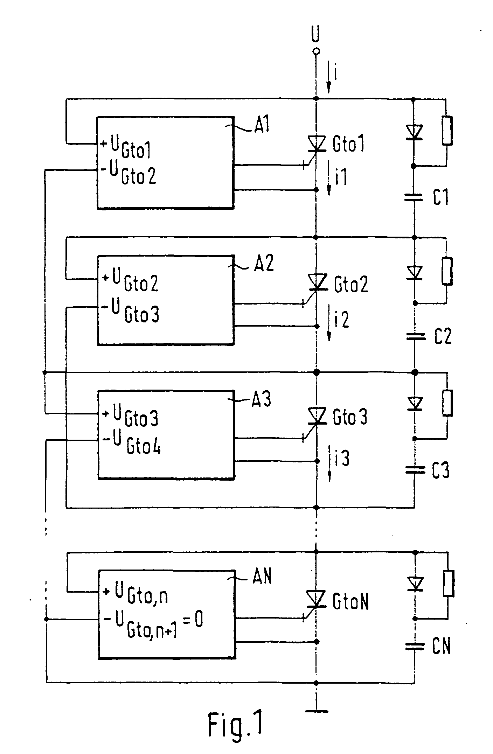

Fig. 1 zeigt den Zweig einer Stromrichterschaltung mit einer Anzahl n in Reihe geschalteter GTO-Thyristoren Gto1, Gto2, Gto3...GtoN mit den zugehörigen Beschaltungskondensatoren C1, C2, C3...CN und den Ansteuerschaltungen A1, A2, A3...AN. An der Reihenschaltung liegt eine Gesamtspannung U.

An den Eingängen der Ansteuerschaltung liegt die Anodenspannung des zugehörigen GTO-Thyristors und die Kathodenspannung des in der Reihenschaltung folgenden GTO-Thyristors, beispielweise liegt an der Ansteuerschaltung A1 die Spannung $+U_{Gto1}$ und die Spannung $-U_{Gto2}$. An die Ansteuerschaltung AN des letzten GTO-Thyristors GtoN in der Reihenschaltung wird die eigene Anodenspannung $+U_{Gton}$ angeschlossen, an den zweiten Eingang wird die eigene Kathodenspannung $- U_{Gton}$ angeschlossen, die Eingangsspannung ist dann Null. Die Sperrspannung an diesem letzten GTO-Thyristor GtoN ist der Referenzwert für alle anderen Sperrspannungen. Die Spannungen beziehen sich auf das Kathodenpotential des der Ansteuerschaltung An zugeordneten GTO-Thyristors Gto,n. Am Ausgang der Ansteuerschaltung An wird ein Signal zur Steuerung des Gatestromes bereitgestellt.

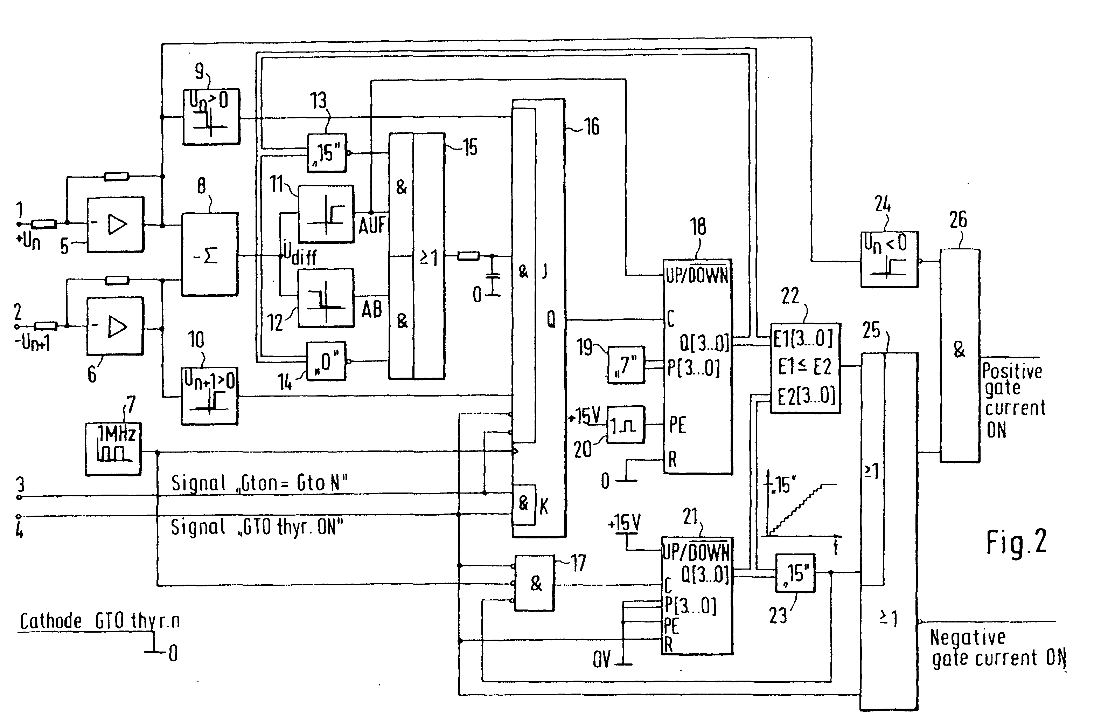

In Fig. 2 ist die Schaltungsanordnung einer Ansteuerschaltung An detailliert dargestellt. Gemäß Fig. 2 besteht die Schaltungsanordnung im wesentlichen aus zwei Operationsverstärkern 5, 6 zur Pegelwandlung, einer Summierschaltung 8 sowie einer logischen Ansteuerschaltung 9...16 für einen Vorwärts-Rückwärts-Zähler 18 und einer logischen Ausgabeschaltung 21...26. Auf die nicht oder nur zusammenfassend genannten Baugruppen der Schaltungsanordnung wird im Zusammenhang mit der Beschreibung der Wirkungsweise der Schaltungsanordnung näher hingewiesen.

An dem ersten Eingang 1 der Schaltung liegt die Anodenspannung $+U_n$ eines GTO-Thyristors Gton, am zweiten Eingang 2 liegt die Kathodenspannung $-U_{n+1}$ des in der Reihenschaltung unmittelbar benachbarten GTO-Thyristors Gto, n+1. Am dritten Eingang 3 liegt ein Signal, das den letzten GTO-Thyristor GtoN in den Reihenschaltung charakterisiert; es liegt bei der Ansteuerschaltung des letzten GTO-Thyristors auf High-Pegel, an den übrigen Ansteuerschaltungen auf Low-Pegel. Am vierten Eingang 4 liegt das Signal "GTO-Thyristor EIN", das von einem hier nicht dargestellten Steuergerät für die GTO-Thyristoren geliefert wird.

Die Thyristorspannung $+ U_n$ am ersten Eingang 1 der Schaltung wird über einen ersten Operationsverstärker 5 und die Thyristorspannung $-U_{n+1}$ am zweiten Eingang 2 der Schaltung wird über einen zweiten Operationsverstärker 6 auf die Pegel der folgenden elektronischen Schaltung herabgesetzt.

Die Wirkungsweise der Erfindung beruht darauf, daß aus einer Spannungsdifferenz $U_{diff}$ eine zeitliche Verschiebung des Löschbeginns der GTO-Thyristoren, in Fig. 2 mit "negativer Gatestrom EIN" bezeichnet, ermittelt wird. Dazu wird ein Vorwärts-Rückwärts-Zähler 18 als digitaler Integrator eingesetzt. Mit dem Einschalten der Versorgungsspannung 20 wird der Vorwärts-Rückwärts-Zähler 18, dessen Zählerbereich 0 bis 15 beträgt, auf dem mittleren Zählerstand "7" gesetzt, Schaltsymbol 19. Der gesamte Zählerbereich repräsentiert den Zeitbereich, in dem das Signal "negativer Gatestrom EIN" liegen kann. Der mittlere Zählerstand "7" verbleibt bei der Ansteuerschaltung AN des letzten GTO-Thyristors Gto N auf diesem Wert, so daß somit dieser Zählerstand Referenzwert wird und es möglich wird, entsprechend dem Zählerstand den Löschbeginn zeitlich gegenüber dem letzten GTO-Thyristor vorzuziehen oder zu verzögern.

Zunächst wird aus den Ausgangsspannungen des ersten Operationsverstärkers 5 und des zweiten Operationsverstärkers 6 mit einer Summierschaltung 8 eine Spannungsdifferenz $U_{diff}$ gebildet, die der Spannungsdifferenz $U_{diff}$ der Eingangsspannungen $+U_n$ und $-U_{n+1}$ der Ansteuerschaltung AN entspricht.

$$U_{diff} = U_n - U_{n+1}$$

$U_{diff} > 0$      Spannung am GTO-Thyristor Gto,n ist größer als die Spannung am folgenden, benachbarten GTO-Thyristor Gto,n+1

$U_{diff} < 0$      Spannung am GTO-Thyristor Gto,n ist kleiner als die Spannung am folgenden, benachbarten GTO-Thyristor Gto,n+1

Mit einer ersten Triggerschaltung 9 wird bewirkt, daß die Sperrspannungsausgleichsregelung nur erfolgt, wenn die Spannung am GTO-Thyristor Gto,n positiv ist, d.h. $U_n > 0$. Eine möglicherweise auftretende negative Spannung am GTO-Thyristor beeinflußt die Sperrspannungsausgleichsregelung nicht.

Mit einer zweiten Triggerschaltung 10 wird sichergestellt, daß die Sperrspannungsausgleichsregelung nur erfolgt, wenn die Spannung am folgenden, benachbarten GTO-Thyristor Gto,n+1 positiv ist, d.h. $U_{n+1} > 0$.

Die Sperrspannungsausgleichsregelung unterbleibt, wenn die Spannung negativ ist. Sie unterbleibt ebenfalls beim letzten GTO-Thyristor GtoN in einer Reihenschaltung, dessen Löschzeitpunkt somit zum Referenzwert für die GTO-Thyristoren einer Reihenschaltung wird. Mit der Bedingung $U_{n+1} > 0$ wird auch gesichert, daß die Sperrspannungsausgleichsregelung abgebrochen wird, falls ein dem betrachteten GTO-Thyristor Gto,n benachbarter GTO-Thyristor Gto,n+1 defekt ist und seine Sperrfähigkeit verliert.

Mit einer dritten Triggerschaltung 11 wird ein Signal zum Aufwärtszählen erzeugt, wenn die Spannungsdifferenz $U_{diff}$ größer als ein fest eingestellter Grenzwert ist.

Mit einer vierten Triggerschaltung 12 wird ein Signal zum Abwärtszählen erzeugt, wenn die Spannungsdifferenz $U_{diff}$ negativ, im Betrag aber größer als der fest eingestellte Grenzwert ist.

Mit dem Grenzwert wird festgelegt, welche Abweichung von der idealen Spannungsverteilung in der Reihenschaltung der GTO-Thyristoren zugelassen werden soll. Absolut gleichgroße Teilspannungen würden einen Grenzwert U = 0 bedingen. Praktisch werden aber Toleranzen zugelassen, so daß der Grenzwert beispielsweise bei 100 V bei einer Teilspannung von 1000V liegen könnte.

Mit einer ersten logischen Schaltung 14 wird der Zählerstand des Vorwärts-Rückwärts-Zählers 18 auf "0", mit einer zweiten logischen Schaltung 13 wird der Zählerstand des Vorwärts-Rückwärts-Zählers 18 auf "15" begrenzt. Die Ausgangssignale der dritten Triggerschaltung 11, der vierten Triggerschaltung 12, der ersten logischen Schaltung 14 und der zweiten logischen Schaltung 13 werden über eine dritte logische Schaltung 15 miteinander verknüpft, deren Ausgangssignal mit den Ausgangssignalen der ersten Triggerschaltung 9 und der zweiten Triggerschaltung 10 die Bedingungen für das Setzen eines J-K-Flip-Flops 16 in jeder Ausschaltphase des GTO-Thyristors Gto,n liefern, so daß einmal in jeder Ausschaltphase ein Zählimpuls, der von einem Taktgenerator 7 geliefert wird, an den Vorwärts-Rückwärts-Zähler 18 abgegeben wird. Damit wird gewährleistet, daß der Zählerstand unabhängig von der Länge der Ausschaltphase gebildet wird. Die Rücksetzung des J-K-Flip-Flops 16 erfolgt über den Eingang 4 mit den Signal "GTO-Thyristor EIN". Das J-K-Flip-Flop 16 wird gesperrt in der Ansteuerschaltung AN des letzten GTO-Thyristors GtoN in der Reihenschaltung, so daß dann keine Verstellung des Vorwärts-Rückwärts-Zähler 18 erfolgt und der Zählerstand auf dem mittleren Wert "7" verbleibt. Mit einer Vergleichsschaltung 22 wird nunmehr der Zählerstand des Vorwärts-Rückwärts-Zählers 18 mit dem Ausgangssignal eines Stufengenerators verglichen und somit der Zählerstand in einen definierten Löschzeitpunkt für den GTO-Thyristor Gto,n umgewandelt, nämlich Zählerstand kleiner als sieben bedeutet, der Löschzeitpunkt des GTO-Thyristors Gto,n liegt vor dem Löschzeitpunkt des letzten GTO-Thyristors GtoN und Zählerstand größer als sieben bedeutet, der Löschzeitpunkt des GTO-Thyristors Gto,n liegt nach dem Löschzeitpunkt des letzten GTO-Thyristors GtoN.

Der Stufengenerator wird mit einem Zähler 21 realisiert, der über eine vierte logische Schaltung 17 die Taktfreigabe des von dem Taktgenerator 7 erzeugten Taktes mit dem negierten Signal "GTO-Thyristor EIN", was gleichbedeutend ist mit dem Signal "GTO-Thyristor AUS" erhält und dessen Zählbereich 0...15 über eine begrenzende Schaltung 23 auf den maximalen Zählerstand "15" festgelegt wird. Die Rücksetzung des Zählers 21 erfolgt mit dem Signal "GTO-Thyristor EIN".

Die Vergleichsschaltung 22 liefert ein Ausgangssignal mit High-Pegel, wenn das Ausgangssignal des Stufengenerators, somit der Zählerstand des Zählers 21, mit dem Zählerstand des Vorwärts-Rückwärts-Zählers 18 übereinstimmt.

Mit der Frequenz des Taktgenerators 7 und dem Zählvolumen des Zählers 21 wird der zeitliche Bereich für die mögliche Verschiebung des Löschzeitpunktes entsprechend dem gewünschten Einsatzfall bestimmt. Im Ausführungsbeispiel ist dieser Bereich mit einer Taktfrequenz f = 1 MHz und dem Zählvolumen "0...15" auf 0 bis 15 µs festgelegt.

Mit einer fünften logischen Schaltung 25 wird der positive Gatestrom des GTO-Thyristors Gto,n abgeschaltet und der negative Gatestrom eingeschaltet, wenn die Bedingung "GTO-Thyristor EIN", Eingang 4, nicht mehr vorhanden ist und das Ausgangssignal der Vergleichsschaltung 22 den High-Pegel angenommen hat oder wenn der Zähler 21 seinen Endwert "15" erreicht hat.

Über eine fünfte Triggerschaltung 24 und ein UND-Gatter 26 wird gewährleistet, daß in den Anwendungsfällen, in denen auch negative Sperrspannung, $U_n < 0$, am GTO-Thyristor liegt, beispielsweise in Stromzwischenkreisumrichtern, der positive Gatestrom unterdrückt wird, solange die Sperrspannung negativ ist.

Die Steuerung eines GTO-Thyristors Gto,n erfolgt in der Praxis von der Ansteuerschaltung AN über eine in Fig. 2 nicht dargestellte Verstärkerschaltung.

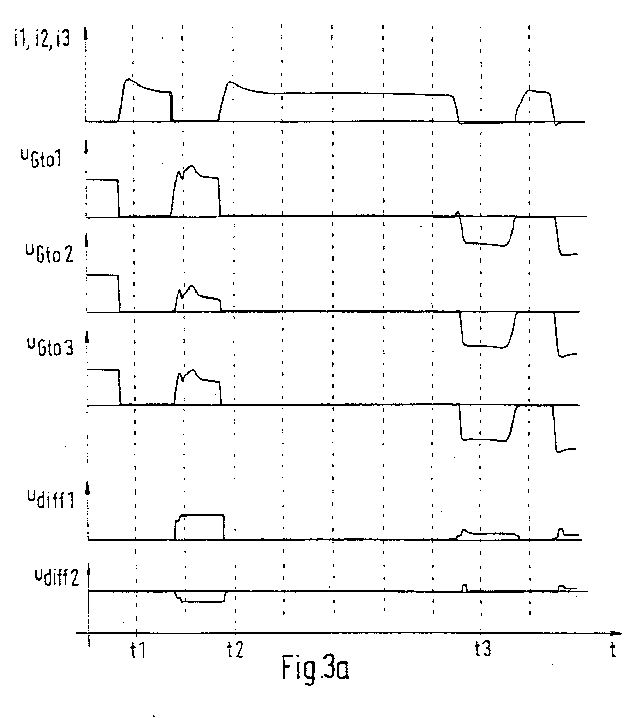

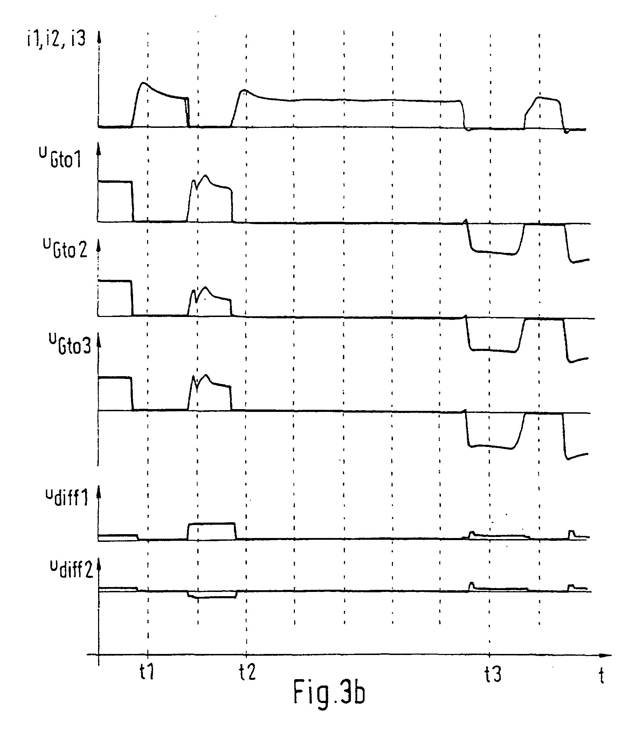

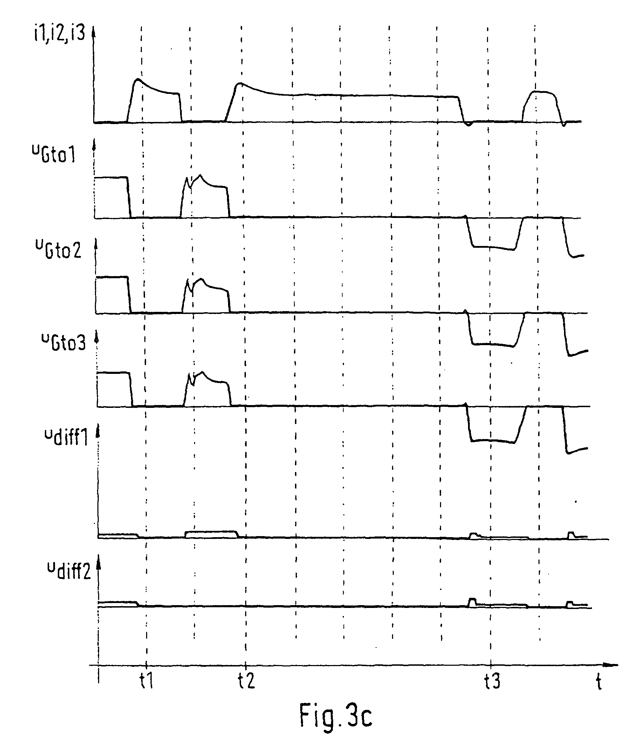

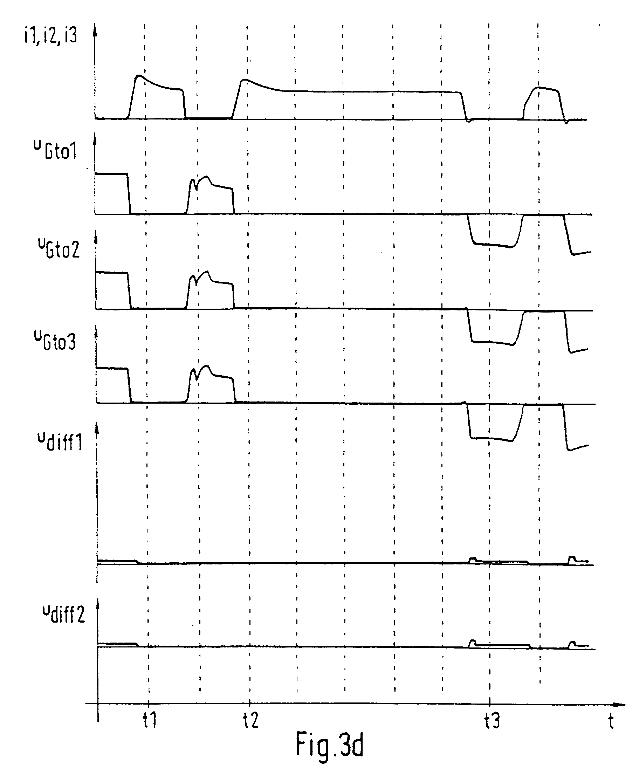

Aus den Figuren 3a, 3b, 3c, 3d geht die Wirkung der Sperrspannungsausgleichsregelung in vier zeitlich aufeinanderfolgenden Ausschaltphasen der Schaltungsanordnung in einem Zweig eines Stromzwischenkreisumrichters mit drei in Reihe geschalteten GTO-Thyristoren Gto1, Gto2, Gto 3 hervor. Dabei ist besonders der Zeitbereich zwischen t=t1 und t=t2 beachtenswert, in dem durch ein Signal "GTO-Thyristor AUS" oder gleichbedeutend "negativer Gatestrom EIN" die jeweiligen Thyristorströme i1, i2, i3 abgeschaltet werden.

Fig. 3a zeigt die unterschiedlichen Spannungen $U_{Gto1}$, $U_{Gto2}$, $U_{Gto3}$ an den jeweiligen GTO-Thyristoren Gto1, Gto2, Gto3 und die daraus ermittelten Spannungsdifferenzen

$$U_{diff1} = U_{Gto1} - U_{Gto2} \qquad U_{diff} > 0$$

$$U_{diff2} = U_{Gto2} - U_{Gto3} \qquad U_{diff} < 0$$

Aus den Fig. 3b, 3c ist zu entnehmen, wie diese Spannungsdifferenzen von Ausschaltphase zu Ausschaltphase geringer werden und schließlich wie in Fig. 3d dargestellt, zu Null werden. In Fig. 3d ist der angestrebte Zustand erreicht, die Spannungen $U_{Gto1}$, $U_{Gto2}$, $U_{Gto3}$ haben gleiche Augenblickswerte, die Teilspannungen in der Reihenschaltung der GTO-Thyristoren sind gleich.

Die um den Zeitpunkt t3 auftretende negative Spannung am GTO-Thyristor hat keinen Einfluß auf die Sperrspannungsausgleichsregelung.

Mit der Erfindung wird ein Verfahren zur Sperrspannungsausgleichsregelung angegeben, das mit einer klar strukturierten und damit einer sehr zuverlässig arbeitenden digitalen Schaltung realisiert wird.

# EP 0 924 860 B1

**Patentansprüche**

1. Verfahren zur Sperrspannungsausgleichsregelung in einer Reihenschaltung unterschiedlich lange Abschaltzeiten aufweisender, gategesteuerter Halbleiter (Gto1, Gto2...Gto,n), bei denen durch Verschiebung der Löschzeitpunkte ein Sperrspannungsausgleich erreicht wird, **dadurch gekennzeichnet,**
   **daß** die Sperrspannungen der in Reihe geschalteten gategesteuerten Halbleiter (Gto1, Gto2, Gto3...Gto,n) jeweils mit der Sperrspannung eines ausgewählten gategesteuerten Halbleiters der Reihenschaltung verglichen werden,
   **daß** die Sperrspannung dieses ausgewählten gategesteuerten Halbleiters in einen Zählerstand eines Vorwärts-Rückwärts-Zählers (18) umgewandelt wird, der in der Mitte zwischen minimalem und maximalem Zählerstand liegt,
   **daß** das Vergleichsergebnis des Vergleichs zwischen Sperrspannung der gategesteuerten Halbleiter (Gto1, Gto2, Gto3...Gto,n) und der Sperrspannung des ausgewählten gategesteuerten Halbleiters als Spannungsdifferenz ($U_{diff}$) in Abhängigkeit vom Vorzeichen in eine Erhöhung oder eine Erniedrigung des mittleren Zählerstandes des Vorwärts-Rückwärts-Zählers (18) umgewandelt wird und daß in Abhängigkeit von dem jeweiligen, einem gategesteuerten Halbleiter (Gto1, Gto2, Gto3...Gto,n) zugeordneten Zählerstand des Vorwärts-Rückwärts-Zählers (18) eine Verschiebung des Löschzeitpunktes im Vergleich zum Löschzeitpunkt des ausgewählten gategesteuerten Halbleiters der Reihenschaltung derart erfolgt, daß eine gleichmäßige Aufteilung der Gesamtspannung (U) der Reihenschaltung auf die die Reihenschaltung bildenden gategesteuerten Halbleiter (Gto1, Gto2, Gto3...Gto, n) erfolgt.

2. Verfahren nach Anspruch 1, **dadurch gekennzeichnet, daß** als ausgewählter gategesteuerter Halbleiter der in positiver Stromrichtung letzte gategesteuerte Halbleiter (GtoN) der Reihenschaltung definiert ist.

3. Verfahren nach Anspruch 1, **dadurch gekennzeichnet, daß** bei positiver Spannungsdifferenz ($U_{diff}$) eine Erhöhung des mittleren Zählerstandes des Vorwärts-Rückwärts-Zählers (18) erfolgt und daß bei negativer Spannungsdifferenz ($U_{diff}$) eine Erniedrigung des mittleren Zählerstandes des Vorwärts-Rückwärts-Zählers (18) erfolgt.

4. Schaltungsanordnung zur Durchführung des Verfahrens nach einem der Ansprüche 1 bis 3, **dadurch gekennzeichnet, dass** jedem gategesteuerten Halbleiter (Gto1, Gto2, Gto3 ... Gto,n) eine Ansteuerschaltung (A1, A2, A3 ... An) zugeordnet ist, deren erster Eingang mit der Anode des gategesteuerten Halbleiters (Gto,n), dem die Ansteuerschaltung (An) zugeordnet ist, verbunden ist, und außer bei dem in positiver Stromrichtung letzten gategesteuerten Halbleiter (GtoN) deren zweiter Eingang mit der Kathode des in positiver Stromrichtung folgenden benachbarten gategesteuerten Hableiters (Gto, n+1) verbunden ist,
   dass der Ausgang der Ansteuerschaltung (A1, A2, A3 ... An) an den Gateanschluss des gategesteuerten Halbleiters (Gto1, Gto2, Gto3 ... Gto,n) geschaltet ist, dass der erste und zweite Eingang der Ansteuerschaltung (A1, A2, A3 ... An) über einen jeweiligen Pegelwandler (5, 6) an eine Summierschaltung (8) angeschlossen sind, deren Ausgang mit dem Eingang einer Triggerschaltung (11) verbunden ist, deren Ausgang wiederum an den UP/DOWN-Eingang eines Vorwärts-Ruckwärts-Zählers (18) geschaltet ist,
   und dass der Ausgang des Vorwärts-Rückwärts-Zählers (18) und der Ausgang eines als Stufengenerator wirkenden Zählers (21) an die Eingänge einer Vergleichsschaltung (22) geschaltet sind, an deren Ausgang ein Signal zur Löschung des gategesteuerten Halbleiters (Gto1, Gto2, Gto3 ... Gto,n) bereitgestellt ist.

**Claims**

1. Method for regulating blocking voltage equalisation in a series connection with gate-controlled semiconductors (Gto 1, Gto 2 ... Gto,n) which have turn-off times of different lengths, in which through the displacement of the turn-off times, blocking voltage equalisation is achieved,
   **characterised in that**
   the blocking voltages of the gate-controlled semiconductors (Gto 1, Gto 2, Gto 3 ... Gto,n), which are switched in series, are in each case compared with the blocking voltage of a selected gate-controlled semiconductor of the series connection,
   the blocking voltage of this selected gate-controlled semiconductor is converted into a counter reading of a bi-directional counter (18), which lies in the middle between the minimum and maximum counter readings,
   the result of the comparison between the blocking voltage of the gate-controlled semiconductors (Gto 1, Gto 2, Gto 3 ... Gto,n) and of the blocking voltage ofthe selected gate-controlled semiconductor is converted, as a voltage difference ($U_{diff}$), into an increase or lowering of the medial counter reading of the bi-directional counter (18) depending on the polarity sign, and that depending on the respective counter reading of the bi-directional counter (18), which [reading] is assigned to a gate-controlled semiconductor (Gto 1, Gto 2, Gto 3 ... Gto,n), the turn-off time is displaced in comparison with the turn-off time of the selected gate-controlled semiconductor of the series connection, in such a way that total voltage (U) of the series connection is distributed evenly over the gate-controlled semiconductors (Gto 1, Gto 2, Gto 3 ... Gto,n) which form the series connection.

2.  Method in accordance with claim 1, **characterised in that** the last gate-controlled semiconductor (GtoN) of the series connection in the positive current direction is defined as the selected gate-controlled semiconductor.

3.  Method in accordance with claim 1, **characterised in that** in the case of a positive voltage difference ($U_{diff}$), the medial counter reading of the bi-directional counter (18) is increased, and that in the case of a negative voltage difference ($U_{diff}$), the medial counter reading of the bi-directional counter (18) is lowered.

4.  Switching arrangement for carrying out the method in accordance with one of the claims 1 to 3,
    **characterised in that**
    assigned to each gate-controlled semiconductor (Gto 1, Gto 2, Gto 3 ... Gto,n) is a trigger circuit (A1, A2, A3 ... An) whose first input is connected to the anode of the gate-controlled semiconductor (Gto,n) to which the trigger circuit (An) is assigned, and - apart from the last gate-controlled semiconductor (GtoN) in the positive voltage direction - whose second input is connected to the cathode of the neighbouring gate-controlled semiconductor (Gto, n+1) in the positive voltage direction;
    that the output of the trigger circuit (A1, A2, A3 ... An) is switched to the gate connection of the gate-controlled semiconductor (Gto 1, Gto 2, Gto 3 ... Gto,n);
    that the first and second inputs of the trigger circuit (A1, A2, A3 ... An) are connected via a respective level converter (5, 6) to a summing circuit (8), whose output is connected to the input of a trigger circuit (11), whose output in turn is switched to the UP/DOWN input of a bi-directional counter (18);
    and that the output of the bi-directional counter (18) and the output of a counter (21) that acts as a step generator is switched to the inputs of a comparator circuit (22), at whose output a signal is provided for turning off the gate-controlled semiconductor (Gto 1, Gto 2, Gto 3 ... Gto,n).

## Revendications

1.  Procédé de réglage de l'égalisation de la tension de blocage dans un circuit en série de semi-conducteurs à commande par la gâchette (Gto1, Gto2 ... Gto,n) ayant des temps de désexcitation de longueurs différentes, dans lequel une égalisation de la tension de blocage est obtenue grâce à un décalage des moments de désamorçage par la gâchette,
    **caractérisé**
    **en ce que** les tensions de blocage des semi-conducteurs à commande par la gâchette (Gto1, Gto2, Gto3 ... Gto, n) reliés en série sont comparées respectivement à la tension de blocage d'un semi-conducteur à commande par la gâchette choisi dans le circuit en série,
    **en ce que** la tension de blocage de ce semi-conducteur à commande par la gâchette choisi est convertie en un état de comptage d'un compteur-décompteur (18) qui se situe à mi-chemin entre l'état de comptage minimum et l'état de comptage maximum,
    **en ce que** le résultat de la comparaison entre la tension de blocage des semi-conducteurs à commande par la gâchette (Gto1, Gto2, Gto3 ... Gto,n) et la tension de blocage du semi-conducteur à commande par la gâchette choisi est converti en tant que différence de tension ($U_{diff}$), en fonction du signe, en une augmentation ou une diminution de l'état de comptage moyen du compteur-décompteur (18) et en ce que, en fonction de l'état de comptage respectif du compteur-décompteur (18) affecté à un semi-conducteur à commande par la gâchette (Gto1, Gto2, Gto3 ... Gto,n), il se produit un décalage du moment de désamorçage du semi-conducteur à commande par la gâchette choisi dans le circuit en série de telle sorte que la tension totale (U) du circuit en série se répartit uniformément entre les semi-conducteurs à commande par la gâchette (Gto1, Gto2, Gto3 ... Gto,n) formant le circuit en série.

2.  Procédé selon la revendication 1, **caractérisé en ce que** le semi-conducteur à commande par la gâchette (GtoN) qui est le dernier du circuit en série dans le sens positif du courant est défini en tant que semi-conducteur à commande par la gâchette choisi.

3.  Procédé selon la revendication 1, **caractérisé en ce qu'**une différence de tension ($U_{diff}$) positive produit une augmentation de l'état de comptage moyen du compteur-décompteur (18) et **en ce qu'**une différence de tension ($U_{diff}$) négative produit une diminution de l'état de comptage moyen du compteur-décompteur (18).

4.  Agencement de circuit pour réaliser le procédé selon l'une des revendications 1 à 3, **caractérisé en ce qu'**il est affecté à chaque semi-conducteur à commande par la gâchette (Gto1, Gto2, Gto3 ... Gto,n) un circuit d'attaque (A1, A2, A3 ... An) dont la première entrée est reliée à l'anode du semi-conducteur à commande par la gâchette (Gto,n) auquel est affecté le circuit d'attaque (An) et dont la deuxième entrée, sauf dans le cas du semi-conducteur à commande par la gâchette qui est le dernier dans le sens positif du courant, est reliée à la cathode du semi-conducteur à commande par la gâchette immédiatement suivant (Gto, n+1), **en ce que** la sortie du circuit d'attaque (A1, A2, A3 ... An) est connectée à la borne de gâchette du semi-conducteur à commande par la gâchette (Gto1, Gto2, Gto3 ... Gto,n), **en ce que** la première et la deuxième entrées du circuit d'attaque (A1, A2, A3 ... An) sont reliées par l'intermédiaire d'un convertisseur de niveau (5, 6) à un circuit sommateur (8) dont la sortie est reliée à l'entrée d'un circuit de déclenchement (11) dont la sortie est à son tour reliée à l'entrée UP/DOWN d'un compteur-décompteur (18) et **en ce que** la sortie du compteur-décompteur (18) et la sortie d'un compteur (21) faisant fonction de générateur de fonction en échelon sont connectées aux entrées d'un circuit comparateur (22) à la sortie duquel est fourni un signal de désamorçage du semi-conducteur à commande par la gâchette (Gto1, Gto2, Gto3 ... Gto,n).

Fig.1

Fig.2

Fig.3a

Fig.3b

Fig.3c

Fig.3d